Europäisches Patentamt

European Patent Office

Office européen des brevets

(19)

(11) Veröffentlichungsnummer : **0 093 727**
**B1**

(12) EUROPÄISCHE PATENTSCHRIFT

(45) Veröffentlichungstag der Patentschrift :
**11.12.85**

(21) Anmeldenummer : **82903044.4**

(22) Anmeldetag : **12.10.82**

(86) Internationale Anmeldenummer :
**PCT/EP 82/00225**

(87) Internationale Veröffentlichungsnummer :
**WO/8301535 (28.04.83 Gazette 83/10)**

(51) Int. Cl.⁴ : **H 01 F 40/06, G 01 R 15/02**

(54) STROMWANDLER.

(30) Priorität : **13.10.81 DE 3140544**

(43) Veröffentlichungstag der Anmeldung :
**16.11.83 Patentblatt 83/46**

(45) Bekanntmachung des Hinweises auf die Patenterteilung : **11.12.85 Patentblatt 85/50**

(84) Benannte Vertragsstaaten :
**AT BE DE FR NL SE**

(56) Entgegenhaltungen :
**DE-A- 2 505 761**
**DE-B- 1 133 817**
**US-A- 2 831 164**

(73) Patentinhaber : **LGZ LANDIS & GYR ZUG AG**
**CH-6301 Zug (CH)**

(72) Erfinder : **FRIEDL, Richard**
**Tiergarten 67**
**D-3300 Braunschweig (DE)**

Jouve, 18, rue St-Denis, 75001 Paris, France

0 093 727

**Beschreibung**

Die Erfindung bezieht sich auf einen Messwandler zum Messen eines Stromes der im Oberbegriff des Anspruchs 1 genannten Art.

Bei solchen Messwandlern wird der zu messende Strom in zwei Teilströme aufgeteilt, die in zwei primärseitigen Teilleitern den Magnetkern gegensinnig durchsetzen, so dass die magnetische Durchflutung des Magnetkerns durch die Differenz der beiden Teilströme bestimmt ist. Die Baugrösse und der Aufwand an Leitermaterial und Magnetkernmaterial kann dadurch im Vergleich zu einem konventionellen Messstromwandler wesentlich reduziert werden.

Es ist ein Messwandler der im Oberbegriff des Anspruchs 1 genannten Art bekannt (US-A-2 831 164), bei dem die Primärwicklung aus einem Metallstreifen geformt ist, der einen rechteckförmigen Querschnitt und in Längsrichtung einen Schlitz aufweist, welcher den Metallstreifen in zwei elektrisch parallele Flachleiter unterteilt. Diese Flachleiter sind derart gegensinnig abgewinkelt, dass sie den Magnetkern gegenläufig durchsetzen. Sie stehen nur an ihren Enden miteinander in engem thermischem Kontakt und sind auf ihrer gesamten freien Länge weitgehend thermisch voneinander entkoppelt.

Der im Anspruch 1 angegebenen Erfindung liegt die Aufgabe zugrunde, einen Messwandler der eingangs genannten Art zu schaffen, bei dem gewährleistet ist, dass die beiden Flachleiter stets die gleiche Temperatur besitzen.

Weiterbildungen der Erfindung sind in den Ansprüchen 2 bis 7 angegeben.

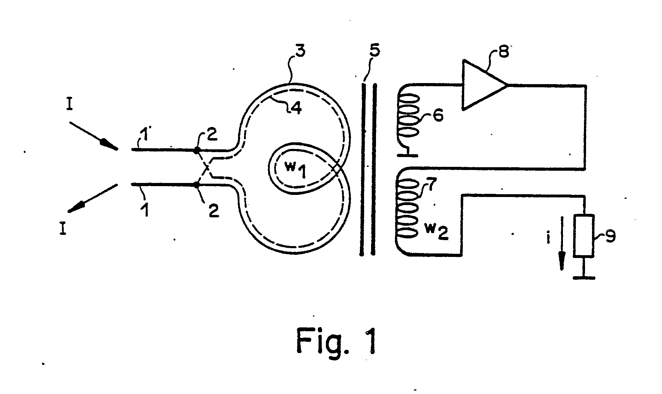

Nachfolgend werden drei Ausführungsbeispiele der Erfindung anhand der Zeichnung näher erläutert. In der Fig. 1 werden prinzipielle Merkmale gezeigt, die zur Erfindung führen. Dabei zeigen

Figur 1  eine Prinzipdarstellung eines Messwandlers mit Durchflutungskompensation,
Figur 2  eine erste Variante einer Primärwicklung,
Figur 3  eine zweite Variante und
Figur 4  eine dritte Variante.

Beim Messwandler nach der Fig. 1 wird ein zu messender Strom I in einem Leiter 1 über Verzweigungspunkte 2 auf zwei voneinander isolierte Leiter 3 und 4 mit den Leiterwiderständen $R_3$ und $R_4$ aufgeteilt, die mit gegenläufigem Windungssinn eine Primärwicklung mit der Windungszahl $w_1$ eines auf der Durchflutungskompensation beruhenden Messwandlers bilden und die auf der gesamten Länge zwischen den Verzweigungspunkten 2 in mechanischem und damit thermischem Kontakt bleiben. Die in den beiden Leitern 3, 4 fliessenden Ströme bewirken eine gegensinnige Durchflutung eines Magnetkerns 5. Eine Detektorwicklung 6 ist mit dem Eingang eines Verstärkers 8 verbunden, dessen Ausgang an eine aus einer Sekundärwicklung 7 und einer Bürde 8 bestehende Reihenschaltung angeschlossen ist. Zusammen mit dem Magnetkern 5, der Detektorwicklung 6, dem Verstärker 8, der Sekundärwicklung 7 mit der Windungszahl $w_2$ und dem Strom i in der Bürde 9 ist das Uebersetzungsverhältnis bei unendlich angenommener Verstärkung des Verstärkers 8

$$i/I = (w_1/w_2) \cdot (R_3 - R_4/R_3 + R_4)$$

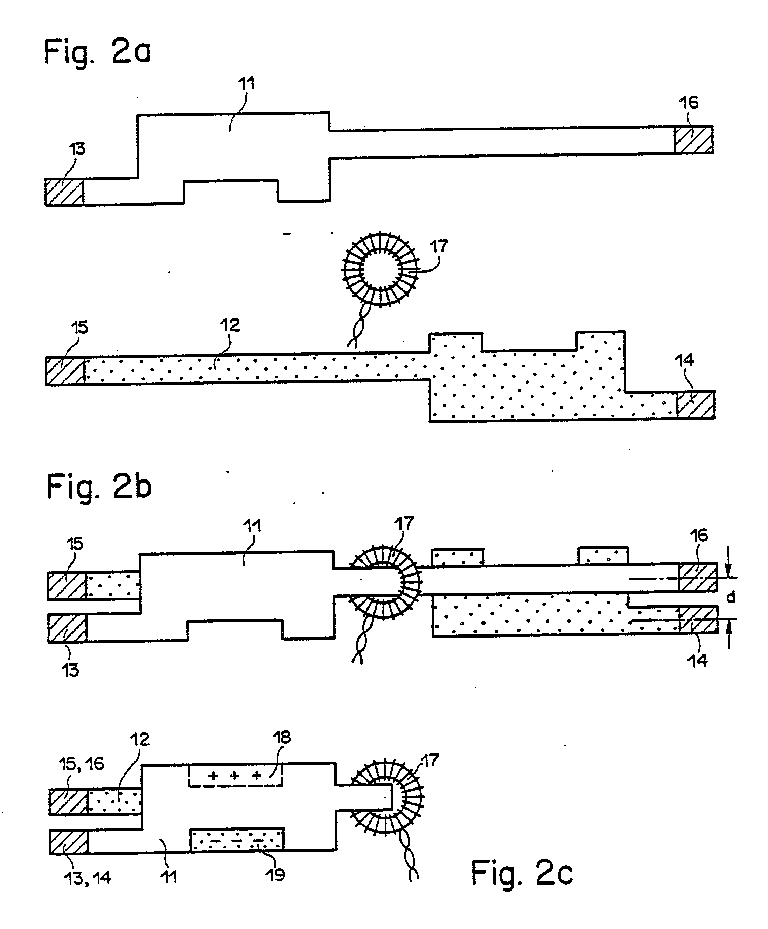

Die in der Fig. 2 dargestellte Primärwicklung besteht aus zwei Flachleitern 11, 12 die vorteilhaft aus Kupferblechen ausgestanzt sind, elektrisch voneinander isoliert sind und deren erste Enden 13, 14 miteinander und deren zweite Enden 15, 16 miteinander elektrisch verbunden sind, wobei diese Verbindung direkt oder über zusätzliche Anschlussleiter die Anschlüsse für den zu messenden Strom bilden. Die von einer Verbindung ausgehenden Flachleiter 11, 12 umfassen einen Magentkern 17 gegensinnig. Ihre elektrischen Widerstände differieren durch unterschiedliche Breiten und/oder Dicken um den Betrag, der zur Erreichung einer gewünschten magnetischen Durchflutungsdifferenz im Magnetkern 17 erforderlich ist. Die Enden 13, 14 bzw. 15, 16 sind quer zur Leiterrichtung und parallel zur Flachseite der Flachleiter 11, 12 um den gewünschten Abstand d für den Stromanschluss versetzt, so dass die Stromanschlüsse ohne besondere Faltungen der Flachleiter 11, 12 nebeneinander zu liegen kommen. Zur Verbesserung des Wärmeaustausches liegen die beiden Flachleiter 11, 12 nahezu auf ihrer gesamten Länge mit je einer ihrer Flachseiten aufeinander, so dass ein konstantes Widerstandsverhältnis der beiden Flachleiter gewährleistet ist.

Die in der Fig. 2a nebeneinander dargestellten Flachleiter 11 und 12 werden gemäss der Fig. 2b durch den als Ringkern ausgebildeten Magnetkern 17 gesteckt und gemäss der Fig. 2c so um den Magnetkern gelegt, dass das Ende 13 des Flachleiters 11 mit dem Ende 14 des Flachleiters 12 und das Ende 16 des Flachleiters 11 mit dem Ende 15 des Flachleiters 12 zusammenfallen und jeweils, gegebenenfalls zusammen mit nicht gezeichneten Anschlussleitern elektrisch verbunden, die Anschlüsse für den zu messenden Strom bilden. Die teilweisen Verbreiterungen der Flachleiter 11, 12 dienen vornehmlich der Verbesserung des Wärmeaustausches, der mechanischen Stabilisierung und der Fixierung der Stromanschlüsse beispielsweise durch Verkleben. An den Stellen 18 und 19 der Flachleiter 11, 12 kann ein nachträglicher primärer, ggf. rechnergesteuerter Betragsabgleich der Wandlerübersetzung in positiver und negativer Richtung vorgenommen werden, indem an einem der Flachleiter 11, 12 beispielsweise durch Bohren, Fräsen oder Sandstrahlen Leitermaterial abgetragen wird.

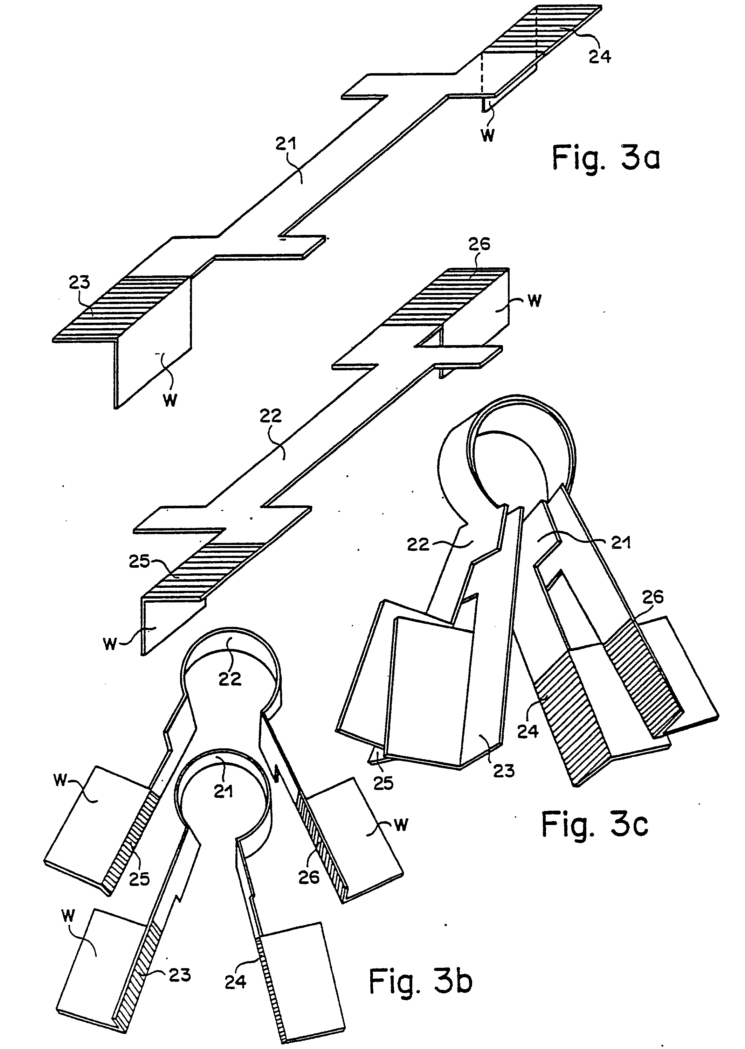

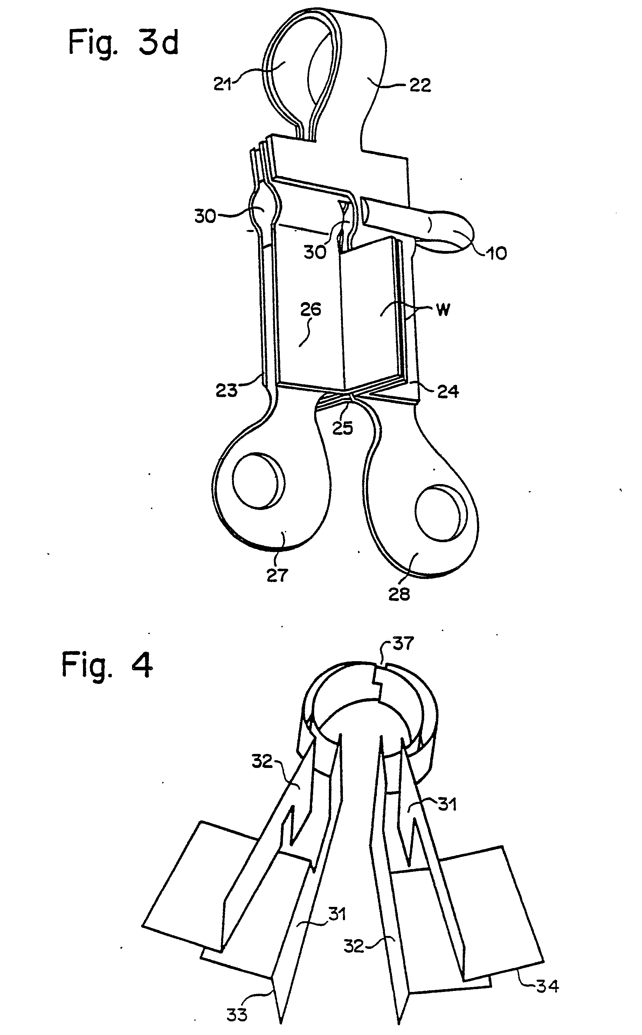

Die Fig. 3 zeigt ein Ausführungsbeispiel einer Primärwicklung mit Flachleitern 21, 22 für Topfkerne.

2

Zwei mit gleichen Flächenabmessungen, aber in der Dicke unterschiedlichen Massen gestanzte Bleche gleicher Art gemäss der Fig. 3a sind bis auf Kontaktflächen 23, 24, 25, 26 mit einer elektrisch isolierenden Schicht (z. B. Lack) überzogen. Die rechtwinklig nach unten abgewinkelten Blechlappen W dienen nach Biegen und Zusammenfügen der Flachleiter 21, 22 der thermischen Kopplung und der mechanischen Stabilisierung zweier Anschlussleiter 27, 28 (Fig. 3d). Die Fig. 3c zeigt das Prinzip der Zusammenfügung der gemäss Fig. 3b vorgeformten Flachleiter 21, 22.

Es werden dabei gemäss der Fig. 3d jeweils die Kontaktflächen 23 und 26 mit dem Anschlussleiter 27 und die Kontaktflächen 25 und 24 mit dem Anschlussleiter 28 elektrisch (beispielsweise durch Löten) miteinander verbunden, während die dabei jeweils aufeinander zu liegen kommenden isolierten Blechlappen W aneinandergeklebt werden.

In der Fig. 3d sind in den Verzweigungen der Flachleiter 21, 22 Sicken 30 angedeutet, in die ein ferromagnetischer Bügel 10 zwecks Kompensation von Phasenfehlern eingeschoben werden kann. Je nach Richtung des Fehlwinkels kann der Kompensationsbügel 10 in die Linke oder rechte Sicke eingeschoben werden. Der Richtungswechsel wird auch erreicht, wenn der Bügel 10 nicht den ersten, oben gezeichneten Flachleiter 22, sondern den zweiten, darunter liegenden Flachleiter 21 umfasst.

Zur Vermeidung des Einflusses von mechanischen Spannungen zwischen den Anschlussleitern 27, 28 auf die Flachleiter 21, 22 der Primärwicklung kann mindestens einer der beiden Anschlussleiter 27, 28 flexibel ausgeführt sein.

Der durch geometrische Unterschiede zwischen den beiden Flachleitern 11, 12 bzw. 21, 22 bedingte Fehlwinkel zwischen dem zu messenden Strom (Primärstrom) und dem Sekundärstrom des Messwandlers kann klein gehalten werden, wenn die Konstruktion so gewählt wird, dass die Winkel der Widerstände der beiden Flachleiter möglichst gleich gross sind.

Das kann vorteilhaft in der Weise geschehen, dass der erste Flachleiter aus zwei an den Enden elektrisch zusammengefassten, den Magnetkern gleichsinnig umfassenden Einzelflachleitern besteht, zwischen denen der zweite, den Magnetkern gegensinnig umfassende Flachleiter eingebettet ist.

Eine andere Möglichkeit zur Angleichung der Winkel der Widerstände der beiden Flachleiter besteht gemäss der Fig. 4 darin, dass zwei Flachleiter 31, 32 mit unterschiedlicher Leiterdicke den gleichen Stanzschnitt besitzen und der erste Flachleiter 31 annähernd auf halbem Weg von seinem ersten Ende 33 zum zweiten Ende 34 beim Umlaufen des nicht gezeichneten Magnetkernes seine geometrische Lage mit dem zweiten, bisher auf ihm aussen liegenden Flachleiter 32 wechselt und nunmehr auf den zweiten Flachleiter 32 zu liegen kommt. Die beiden Flachleiter 31, 32 sind in ihrem Kreuzungsbereich 37 auf einer relativ kurzen Weglänge um etwas mehr als die Hälfte ihrer Breite vom Leitermaterial ausgespart, wodurch der Lagenwechsel ohne Veränderung der Gesamtbreite der übereinander liegenden Flachleiter 31, 32 bewirkt wird.

Die Anwendung den beschriebenen Primärwicklung ist nicht auf Wechselstrom-Messwandler beschränkt. Sie kann gleichermassen die Primärwicklung von Messwandlern bilden, die für die Messung von Gleichströmen oder von Mischströmen konzipiert sind.

## Patentansprüche

1. Messwandler zum Messen eines Stromes, mit einer Primärwicklung, einem Magnetkern (5, 17) und mindestens einer Sekundärwicklung (6, 7), wobei die Primärwicklung aus einem ersten und einem zweiten elektrischen Flachleiter (11, 12, 21, 22, 31, 32) gleichen Leitermaterials besteht, die einen voneinander abweichenden Widerstand aufweisen, an ihren Enden (13 bis 16, 23 bis 26) elektrisch miteinander verbunden und im übrigen elektrisch voneinander isoliert sind, miteinander in thermischem Kontakt stehen und den Magnetkern (5, 17) mit je einer einzigen Windung und gegenläufigem Windungssinn so durchsetzen, dass die magnetische Durchflutung des Magnetkerns (5, 17) durch die Differenz der in den beiden Flachleitern (11, 12, 21, 22, 31, 32) fliessenden Teilströmen bestimmt ist, dadurch gekennzeichnet, dass zur Verbesserung des Warmeaustausches die beiden Flachleiter (11, 12, 21, 22, 31, 32) nahezu auf ihrer gesamten Länge mit je einer ihrer Flachseiten aufeinanderliegen.

2. Messwandler nach Anspruch 1, dadurch gekennzeichnet, dass die Enden (13 bis 16, 23 bis 26) der Flachleiter (11, 12, 21, 22, 31, 32) quer zur Leiterrichtung und parallel zur Flachseite so gegeneinander versetzt sind, dass nach Montage auf den Magnetkern (5, 17) jeweils zwei Enden (13, 14 bzw. 15, 16 ; 23, 26 bzw. 24, 25) verschiedener Flachleiter (11, 12, 21, 22, 31, 32) aneinanderliegen.

3. Messwandler nach Anspruch 1 oder 2, dadurch gekennzeichnet, dass der erste Flachleiter (11, 22) den zweiten Flachleiter (12, 21) nahezu auf seiner ganzen Windungslänge umgibt.

4. Messwandler nach Anspruch 1 oder 2, dadurch gekennzeichnet, dass der erste Flachleiter (31) den zweiten Flachleiter (32) nahezu auf der einen Hälfte seiner Windungslänge und der zweite Flachleiter (32) den ersten Flachleiter (31) nahezu auf der anderen Hälfte seiner Windungslänge umgibt.

5. Messwandler nach einem der vorangehenden Ansprüche, dadurch gekennzeichnet, dass einer der beiden Flachleiter (11, 12, 21, 22, 31, 32) zur Kompensation eines Fehlwinkels von einem ferromagnetischen Element (10) umfasst ist.

6. Messwandler nach Anspruch 5, dadurch gekennzeichnet, dass das ferromagnetische Elemente (10) ein an seinem Ende offener Eisenbügel ist.

7. Messwandler nach einem der vorangehenden Ansprüche, dadurch gekennzeichnet, dass jeder Flachleiter (11, 21, 31 bzw. 12, 22, 32) eine Aussparung (18, 19) aufweist, die eine nachträgliche Abtragung von Leitermaterial am anderen Flachleiter (12, 22, 32 bzw. 11, 21, 31) ermöglicht.

**Claims**

1. An instrument transformer for measuring a current, comprising a primary winding, a magnetic core (5, 17) ant at least one secondary winding (6, 7), wherein the primary winding comprises first and second flat electrical conductors (11, 12, 21, 22, 31, 32) of the same conductor material, which have resistances that differ from each other, which are electrically interconnected at their ends (13 to 16, 23 to 26) and are otherwise electrically insulated from each other and which are in thermal contact with each other and which pass through the magnetic core (5, 17) each with a single turn and in the opposite direction of winding in such a way that the magnetic flux in the magnetic core (5, 17) is determined by the difference of the component currents flowing in the two flat conductors (11, 12, 21, 22, 31, 32) characterised in that in order to enhance heat exchange the two flat conductor (11, 12, 21, 22, 31, 32) lie against each other with a respective one of their flat sides almost over their entire length.

2. An instrument transformer according to claim 1 characterised in that the ends (13 to 16, 23 to 26) of the flat conductors (11, 12, 21, 22, 31, 32) are displaced relative to each other transversely with respect to the conductor direction and parallel to the flat side in such a way that after being fitted on to the magnetic core (5, 17) two ends (13, 14 and 15, 16 respectively ; 23, 26 and 24, 25 respectively) of respectively different flat conductors (11, 12, 21, 22, 31, 32) bear against each other.

3. An instrument transformer according to claim 1 or claim 2 characterised in that the first flat conductor (11, 22) surrounds the second flat conductor (12, 21) almost over the entire length of its turn.

4. An instrument transformer according to claim 1 or claim 2 characterised in that the first flat conductor (31) surrounds the second flat conductor (32) almost over one half of the length of its turn and the second flat conductor (32) surrounds the first flat conductor (31) almost over the other half of the length of its turn.

5. An instrument transformer according to one of the preceding claims characterised in that one of the two flat conductors (11, 12, 21, 22, 31, 32) is embraced by a ferromagnetic element (10) to compensate for a phase angle.

6. An instrument transformer according to claim 5 characterised in that the ferromagnetic element (10) is an iron clip member which is open at its end.

7. An instrument transformer according to one of the preceding claims characterised in that each flat conductor (11, 21, 31 and 12, 22, 32) has a cut-out portion (18, 19) which permits subsequent removal of conductor material on the other flat conductor (12, 22, 32 and 11, 21, 31 respectively).

**Revendications**

1. Transformateur de mesure servant à mesurer un courant, comportant un enroulement primaire, un noyau magnétique (5, 17) et au moins un enroulement secondaire (6, 7) et dans lequel l'enroulement primaire est constitué par un premier et un second conducteurs électriques plats (11, 12, 21, 22, 31, 32) constitués en un même matériau conducteur et qui comportent des résistances différentes, sont reliés électriquement au niveau de leurs extrémités (13 à 16, 23 à 26) et sont par ailleurs isolés électriquement les uns par rapport aux autres, sont en contact thermique réciproque et traversent le noyau magnétique (5, 17), et ce avec des spires uniques respectives et avec des sens opposés d'enroulement, de telle sorte que le flux de courant magnétique du noyau magnétique (5, 17) est déterminé par la différence des courants partiels circulant dans les deux conducteurs plats (11, 12, 21, 22, 31, 32), caractérisé en ce que, pour améliorer l'échange de chaleur, les deux conducteurs plats (11, 12, 21, 22, 31, 32) sont superposés, approximativement sur toute leur longueur, par une de leurs faces planes respectives.

2. Transformateur de mesure selon la revendication 1, caractérisé en ce que les extrémités (13 à 16, 23 à 26) des conducteurs plats (11, 12, 21, 22, 31, 32) sont décalées réciproquement transversalement par rapport à la direction des conducteurs et parallèlement à la face plane de telle sorte qu'après le montage sur le noyau magnétique (5, 17), respectivement deux extrémités (13, 14 ou 15, 16 ; 23, 26 ou 24, 25) de conducteurs plats différents (11, 12, 21, 22, 31, 32) sont appliquées l'une contre l'autre.

3. Transformateur de mesure selon la revendication 1 ou 2, caractérisé en ce que le premier conducteur plat (11, 22) entoure le second conducteur plat (12, 21) approximativement sur toute sa longueur de spire.

4. Transformateur de mesure selon la revendication 1 ou 2, caractérisé en ce que le premier conducteur plat (31) entoure le second conducteur plat (32) approximativement sur une moitié de sa longueur de spire et que le second conducteur plat (32) entoure le premier conducteur plat (32) approximativement sur l'autre moitié de sa longueur de spire.

5. Transformateur de mesure suivant l'une des revendications précédentes, caractérisé en ce que, pour la compensation d'une erreur d'angle, l'un des deux conducteurs plats (11, 12, 21, 22, 31, 32) est entouré par un élément ferromagnétique (10).

**0 093 727**

6. Transformateur de mesure suivant la revendication 5, caractérisé en ce que l'élément ferromagnétique (10) est un étrier en fer (10), ouvert au niveau de son extrémité.

7. Transformateur de mesure selon l'une des revendications précédentes, caractérisé par le fait que chaque conducteur plat (11, 21, 31 ou 12, 22, 32) possède un évidement (18, 19) qui permet un enlèvement ultérieur de matériau conducteur sur l'autre conducteur plat (12, 22, 32) ou (11, 21, 31).

5

Fig. 1

Fig. 2a

Fig. 2b

Fig. 2c

0 093 727

Fig. 3a

Fig. 3c

Fig. 3b

3

Fig. 3d

Fig. 4